(19) Europäisches Patentamt
European Patent Office
Office européen des brevets

(11) **EP 2 362 096 A1**

(12) **EUROPEAN PATENT APPLICATION**
published in accordance with Art. 153(4) EPC

(43) Date of publication:
**31.08.2011 Bulletin 2011/35**

(51) Int Cl.:
*F03G 7/08* (2006.01)          *H01L 41/113* (2006.01)
*H01L 41/187* (2006.01)       *H01L 41/22* (2006.01)
*H01L 41/24* (2006.01)         *H02N 2/00* (2006.01)

(21) Application number: **09829161.0**

(22) Date of filing: **27.11.2009**

(86) International application number:
**PCT/JP2009/070036**

(87) International publication number:
**WO 2010/061916 (03.06.2010 Gazette 2010/22)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **28.11.2008 JP 2008303935
11.08.2009 JP 2009186532**

(71) Applicants:
• **East Japan Railway Company
Tokyo 151-8578 (JP)**
• **JR East Consultants Company
Tokyo 151-0053 (JP)**
• **Kyocera Corporation
Kyoto-shi
Kyoto 612-8501 (JP)**

(72) Inventors:
• **SATO, Toshihiko
Tokyo 151-8578 (JP)**
• **KOBAYASHI, Mitsuaki
Tokyo 151-8512 (JP)**
• **FUKAMI, Jun
Tokyo 151-8512 (JP)**
• **YOSHIMURA, Kenichi
Kirishima-shi
Kagoshima 899-4312 (JP)**
• **ISHIKAWA, Kazuhiro
Kirishima-shi
Kagoshima 899-4396 (JP)**

(74) Representative: **HOFFMANN EITLE
Patent- und Rechtsanwälte
Arabellastraße 4
81925 München (DE)**

(54) **POWER GENERATION MEMBER, POWER GENERATION DEVICE USING SAME, AND POWER GENERATION SYSTEM**

(57)     To provide a power generation member having a high power generating capacity, a power generation device using the same, and a power generation system.

A power generation member 1 includes: a piezoelectric element 2 in which electrodes 2a and 2c are formed on both main faces of a plate-shaped piezoelectric ceramic 2b; a pressing member to press one main face of the piezoelectric element 2; and a support member 4 to support the other main face of the piezoelectric element 2, wherein the support member 4 supports an outer rim of the piezoelectric element 2, and the pressing member 3 presses the piezoelectric element 2 at a part inside the support member 4 with a planar pressing face. It is possible to reduce cancellation of the generated charge, as well as to allow the piezoelectric ceramic 2b to deform sufficiently to produce large strain by pressure energy generated by a walking man or vibration energy generated by a running car and the like. As a result, it is possible to effectively obtain large electricity.

Fig.10

## Description

Background of the Invention

Field of the Invention

The present invention relates to a power generation member having a function of generating electricity from pressure energy generated by a walking man and vibration energy generated by a running car or train, a power generation device using the same, and a power generation system.

Description of the Related Art

In recent years, as clean energy with no $CO_2$ emissions, attention has been focused on power generation systems which generate electricity by extracting voltage generated in piezoelectric ceramics in response to strain produced by utilizing pressure energy generated by a walking man on a floor and stairs of public facilities such as station, airport or department store, or vibration energy generated by a car, train and the like running on a road, bridge, parking lot or railway track.

These power generation systems are composed of a power generation device using a power generation member comprising a piezoelectric ceramic. Some examples of such power generation member, power generation device and power generation system are proposed in JP 2006-197704A, JP H11-353913A and JP H05-39661A.

JP 2006-197704A proposes a power generation system comprising a piezoelectric member installed on a road, where moving objects including men, vehicles and trains pass through, and extracts electricity generated by pressure on the piezoelectric member caused by moving objects passing through over the piezoelectric member. According to the power generation system, it is possible to install it in existing facilities such as railway station. Electricity supply source is passage of men and vehicles themselves, and it is possible to generate electricity in a greatly effective manner.

JP H11-353913A proposes a power generation device in which pressure power generation elements are placed on stair-steps and floors around the stairs, and a battery is connected to the pressure power generation elements. According to the device, it is possible to generate electricity by stamping the pressure power generation elements during going up and down the stairs. Also, the power generation device hardly has trouble even after a long period of use, and can be thus maintenance-free in practical use.

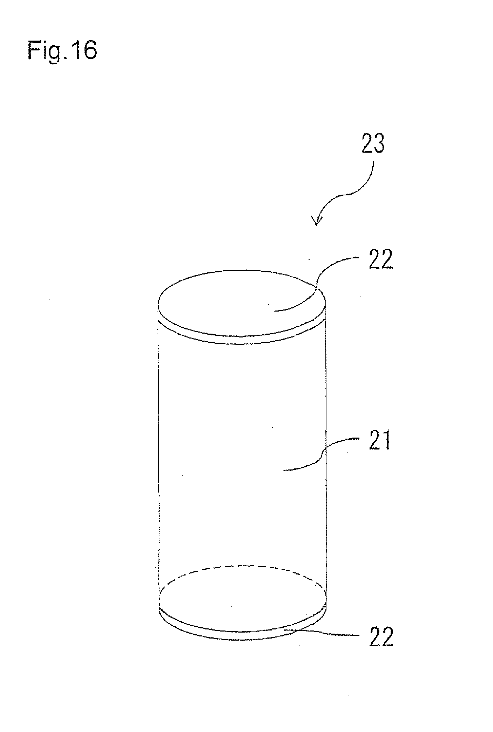

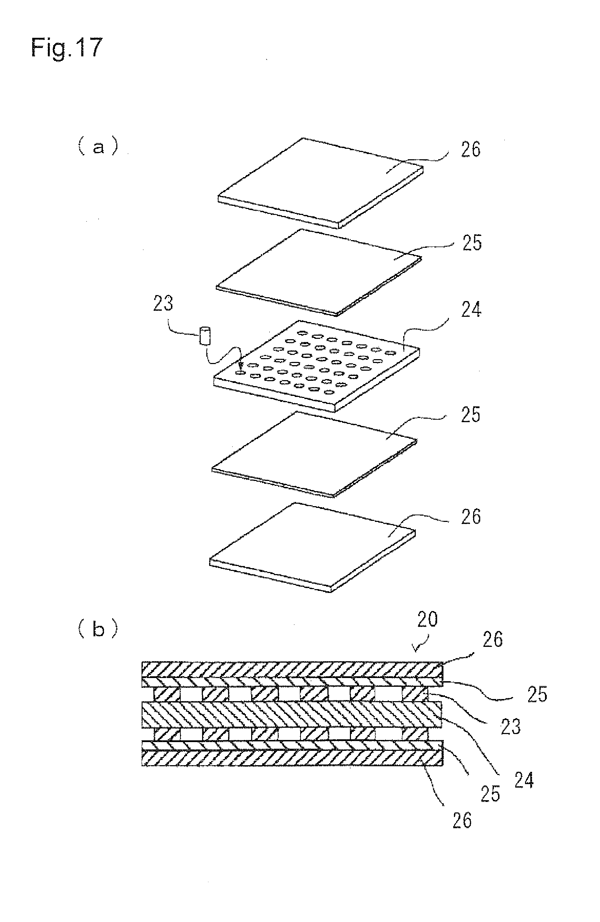

JP H05-39661A proposes an architectural flooring material having a structure that a piezoelectric ceramic is sandwiched with electrodes and thus having a power generating function from external pressure load. Fig. 16 is a perspective view of a piezoelectric element shown in JP 05-39661A, in which metal electrodes are attached to both ends of a piezoelectric ceramic material. Fig. 17 shows the flooring material comprising the piezoelectric element shown in JP H05-39661A, in which Fig. 17(a) is an exploded view of its basic structure, and Fig. 17(b) is a sectional view of the flooring material.

In a piezoelectric element 23 shown in Fig. 16, metal electrodes 22 are formed on both ends of a cylindrical piezoelectric ceramic 21 by deposition or the like. In a flooring material 20, as its basic structure is shown in Fig. 17(a), the piezoelectric elements 23 are fitted in a plurality of holes on a support member 24 having high electric properties. A metal plates 25 sandwiches it so as to be electrically conductive with the metal electrodes 22, and common flooring materials 26 further sandwiches it, in a manner that they are in close contact with each other.

As shown in the sectional view of the flooring material 20 of Fig. 17(b), when the flooring material 20 is subjected to pressure caused by man's body weight and the like, the pressure reaches the piezoelectric elements 23 to generate voltages across its both ends, and the generated voltages are extracted to outside through the metal plates 25. It is possible to lay the flooring material 20 on stairs and corridors so as to supply supplemental electricity for corridor lightings, elevators and escalators, and the flooring material 20 is thus building material which contributes to energy conservation.

However, although the power generation system of JP 2006-197704A is innovative in the point that it does not require building the dedicated facilities because the piezoelectric member can be used for power generation, it does not sufficiently disclose a structure of the piezoelectric member for extracting high voltage and a method of effective power generation.

Also, although the power generation device of JP H11-353913A can effectively utilize energy because the pressure power generation elements can generate electricity by being stamped, sufficient consideration was not made on a method of pressing the pressure power generation elements and it was not exactly possible to obtain large electricity.

JP H05-39661A specifically discloses a method of extracting voltages to generate electricity regarding the flooring material 20. However, it is not possible to obtain large electricity with the flooring material 20. Since the piezoelectric ceramic 21 has a cylindrical shape, it cannot be sufficiently deformed even when pressure by man's body weight or the like reaches the piezoelectric elements 23 via the flooring materials 26 and metal plates 25.

Summary of the Invention

The present invention has been made in order to solve the above problems, and it is an object of the present invention to provide a power generation member having high power generating capacity, a power generation device using the same, and a power generation system.

A power generation member of the present invention includes: a piezoelectric element in which electrodes are formed on both main faces of a plate-shaped piezoelectric ceramic; a pressing member to press one main face of the piezoelectric element; and a support member to support the other main face of the piezoelectric element, wherein the support member supports an outer rim of the piezoelectric element, and the pressing member presses the piezoelectric element with a planar pressing face at a part inside the support member.

Alternatively, a power generation member of the present invention includes: a piezoelectric element in which electrodes are formed on both main faces of a plate-shaped piezoelectric ceramic; a pressing member to press one main face of the piezoelectric element; and a support member to support the other main face of the piezoelectric element, wherein the support member supports an outer rim of the piezoelectric element, and the pressing member presses the piezoelectric element with a ring pressing face at a part inside the support member.

Still alternatively, a power generation member of the present invention includes: a piezoelectric element in which electrodes are formed on both main faces of a plate-shaped piezoelectric ceramic; a pressing member to press one main face of the piezoelectric element; and a support member to support the other main face of the piezoelectric element, wherein the power generation member has a triangular, rectangular, hexagonal or octagonal shape in a planar view.

In the above power generation member of the present invention, the pressing member is composed of a material having a lower hardness than that of the support member.

In any one of the above power generation members of the present invention, the piezoelectric ceramic is composed of lead zirconate titanate.

In any one of the above power generation members of the present invention, the piezoelectric ceramic contains potassium-sodium-lithium niobate as a main component, and further contains calcium titanate and bismuth ferrite.

A power generation device of the present invention includes a plurality of any one of the above power generation members of the present invention, which are arrayed in a plane, wherein plate-shaped first covering members hold the respective pressing members, and plate-shaped second covering members hold the respective support members.

In the above power generation device of the present invention, the pressing members are formed integrally with the respective first covering members.

In the above power generation device of the present invention, the support members are formed integrally with the respective second covering members.

A power generation system of the present invention includes: any one of the above power generation devices of the present invention; and a DC-AC converter connected via a circuit comprising a diode and a capacitor.

In the power generation system of the present invention, any one of the power generation devices of the present invention is placed on a floor, stairs, road, bridge or parking lot or under a railway track.

The power generation member of the present invention includes: a piezoelectric element in which electrodes are formed on both main faces of a plate-shaped piezoelectric ceramic; a pressing member to press one main face of the piezoelectric element; and a support member to support the other main face of the piezoelectric element, wherein the support member supports an outer rim of the piezoelectric element, and the pressing member presses the piezoelectric element with a planar pressing face at a part inside the support member. Therefore, it is possible to allow the piezoelectric ceramic to deform sufficiently so as to produce large strain, and also to reduce cancellation of the generated charge. As a result, it is possible to effectively obtain large electricity.

The power generation member of the present invention includes: a piezoelectric element in which electrode are formed on both main faces of a plate-shaped piezoelectric ceramic; a pressing member to press one main face of the piezoelectric element; and a support member to support the other main face of the piezoelectric element, wherein the support member supports an outer rim of the piezoelectric element, and the pressing member presses the piezoelectric element with a ring pressing face at a part inside the support member. Therefore, it is possible to allow the piezoelectric ceramic to deform sufficiently so as to produce large strain, and also to reduce cancellation of the generated charge. As a result, it is possible to effectively obtain large electricity. Also, since the pressing member has the ring pressing face, it is possible to reduce a weight of the pressing member compared to the pressing member having a planar pressing face. Further, it is possible to form the pressing member itself into a ring shape, and thus to reduce a weight of each power generation member. As a result, it is possible to reduce a weight of the power generation device where a plurality of the power generation members are arrayed in a plane. The reduction in weight of the power generation device also makes it possible to reduce burden on carrying it.

The power generation member of the present invention includes: a piezoelectric element in which electrodes are formed on both main faces of a plate-shaped piezoelectric ceramic; a pressing member to press one main face of the piezoelectric element; and a support member to support the other main face of the piezoelectric element, wherein the power generation member has a triangular, rectangular, hexagonal or octagonal shape in a plan view. Therefore, it is possible to array a plurality of the power generation members closely in a plane with little space between them, and thus to efficiently obtain large electricity.

According to the power generation member of the present invention, if the pressing member is composed of a material having a lower hardness than that of the support member, even when the power generation member is subjected to large pressure energy generated by a walking man or large vibration energy generated by a running car or the like, the pressing member absorbs and buffers such large pressure or vibration energy, and the support member supports the piezoelectric element so as to prevent it from excess deformation. As a result, it is possible to prevent the piezoelectric ceramic constituting the piezoelectric element from breakage.

According to the power generation member of the present invention, when the piezoelectric ceramic is composed of lead zirconate titanate, it is possible to obtain larger electricity since it has high ferroelectricity, which is one of the characteristics affecting power generating capacity.

According to the power generation member of the present invention, when the piezoelectric ceramic contains potassium-sodium-lithium niobate as a main component, and further contains calcium titanate and bismuth ferrite, discontinuation called second-order phase transition hardly occur, which is phase transformation from a ferroelectric phase at lower temperature to that at higher temperature depending on change rates of resonant frequency, antiresonant frequency and piezoelectric constant $g_{33}$ with respect to temperature in a range of -40˚C to +150˚C. Therefore, it is possible to stabilize piezoelectric properties. Also, since it allows lead-free composition, the power generation member can be eco-friendly.

According to the power generation device of the present invention, a plurality of the above power generation member of the present invention may be arrayed in a plane, plate-shaped first covering members may hold the respective pressing members, and plate-shaped second covering members may hold the respective support members. In this case, it is possible to effectively use pressure energy generated by a walking man and vibration energy generated by a running car or the like for power generation. Also, the pressing members and support members are held by the respective first and second covering members, and pressure or vibration energy is transmitted not to a specific power generation member but to a plurality of the power generation members in a dispersed manner. Therefore, the power generation members are resistant to damage, and thus can be used for a long period.

According to the power generation device of the present invention, when the pressing members may be formed integrally with the respective first covering members, relative position between the piezoelectric elements and pressing members does not change because the pressing members are not simply in contact with the respective first covering member but integrally formed together. Also, compared to the case where pressing members are joined or connected to respective first covering members, failure of adhesion or loosing of connectors such as screws does not occur even by repetitive power generation from pressure energy generated by a walking man or vibration energy generated by a running car and the like. Therefore, it is possible to effectively obtain large electricity for a long period.

According to the power generation device of the present invention, when the support members are formed integrally with the respective second covering members, it is possible to effectively obtain large electricity for a long period, since relative position between the piezoelectric elements and support members does not change. Also, since the support members are formed integrally with the respective second covering members, it is possible to omit a joining or connecting step.

The power generation system of the present invention includes: the power generation device of the present invention; and a DC-AC converter connected via a circuit comprising a diode and capacitor. In this case, the pressing members having a planar pressing face or pressing members having a ring pressing face, or the ring pressing members, which are held by the first covering member, are pressed by pressure energy generated by a walking man or vibration energy generated by a running car and the like. The support members held by the second covering members support the outer rims of the piezoelectric elements. Therefore, the piezoelectric ceramics are sufficiently deformed to produce strain, voltage generated by the strain is accumulated to a capacitor through a diode as electric charge, and the accumulated charge is extracted and converted to alternated current with the DC-AC converter. Accordingly, the energy can be used as electricity. Also, in the power generation device provided in the power generation system of the present invention, when the power generation members have a triangular, rectangular, hexagonal or octagonal shape in a plan view, it is possible to array a plurality of the power generation devices closely in a plane with little space between them, and thus to efficiently obtain large electricity. In this case, the plurality of the power generation devices do not necessarily have the same shape in a plan view, but may have different shapes as long as they can be arrayed closely in a plane by combination.

According to the power generation system of the present invention, when the power generation device of the present invention is placed on a floor, stairs, road, bridge or parking lot or under a railway track, it is possible to generate electricity from pressure energy generated by a walking man or vibration energy generated by a running car and the like. Therefore, the power generation system can be an effective measure for energy conservation as well as a clean

system with no $CO_2$ emissions.

Brief Description of the Drawings

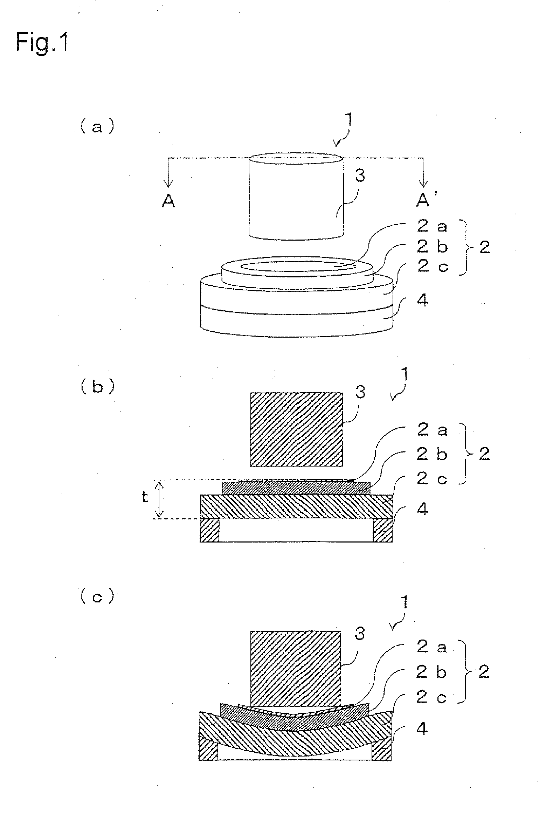

Fig. 1 shows an example of an embodiment of the power generation member of the present invention, in which Fig. 1(a) is a perspective view and Fig. 1(b) is a sectional view taken along lines A-A' of Fig. 1(a). Further, Fig. 1(c) is a sectional view showing a state where a piezoelectric element is pressed by a pressing member.

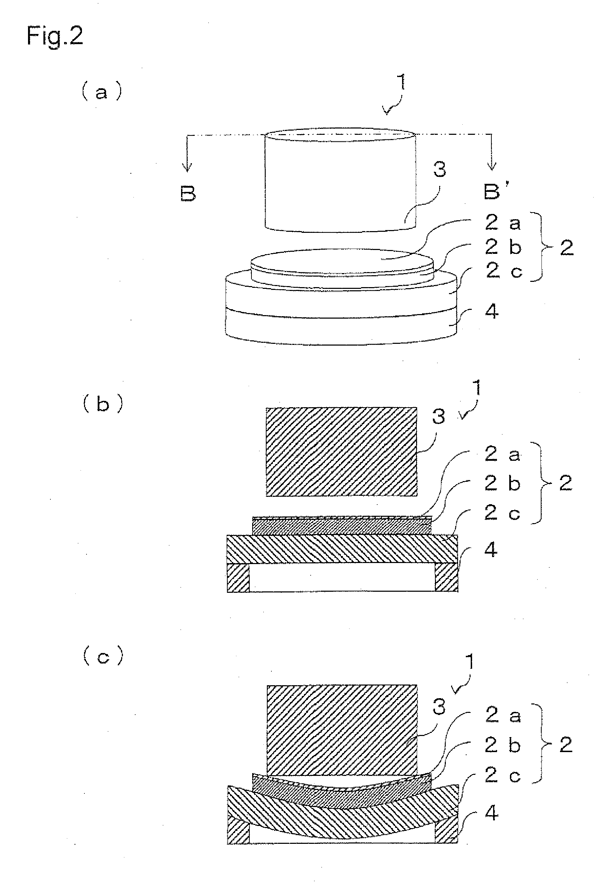

Fig. 2 shows another example of the embodiment of the power generation member of the present invention, in which Fig. 2(a) is a perspective view and Fig. 2(b) is a sectional view taken along lines B-B' of Fig. 2(a). Further, Fig. 2(c) is a sectional view showing a state where a piezoelectric element is pressed by a pressing member.

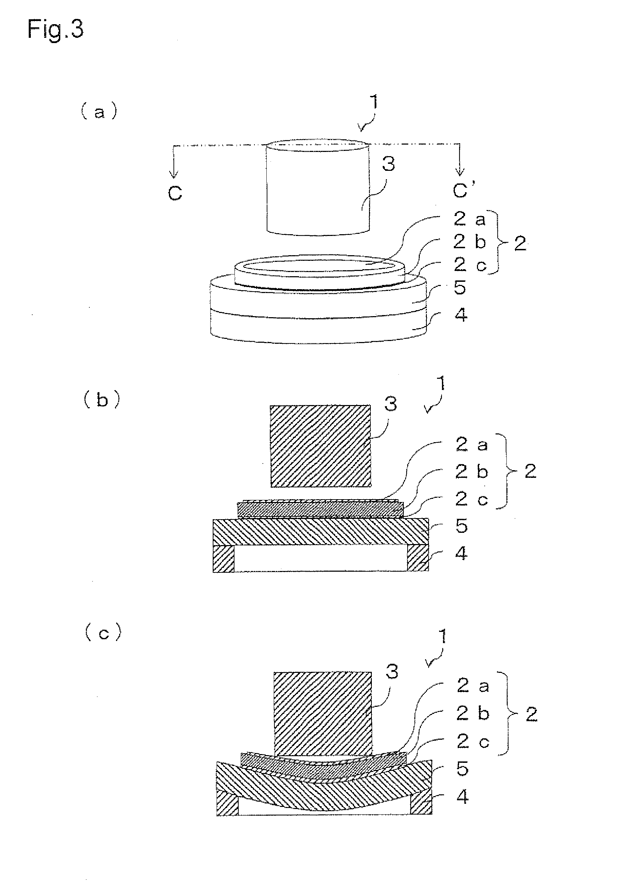

Fig. 3 shows another example of the embodiment of the power generation member of the present invention, in which Fig. 3(a) is a perspective view and Fig. 3(b) is a sectional view taken along lines C-C' of Fig. 3(a). Further, Fig. 3 (c) is a sectional view showing a state where a piezoelectric element is pressed by a pressing member.

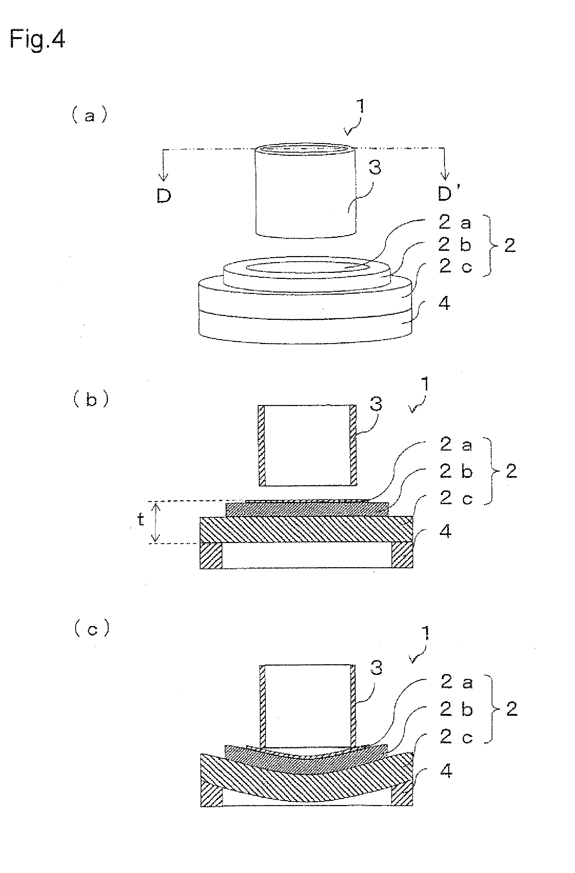

Fig. 4 shows an example of the embodiment of the power generation member of the present invention, in which Fig. 4(a) is a perspective view and Fig. 4(b) is a sectional view taken along lines D-D' of Fig. 4(a). Further, Fig. 4 (c) is a sectional view showing a state where a piezoelectric element is pressed by a ring pressing member having a ring pressing face.

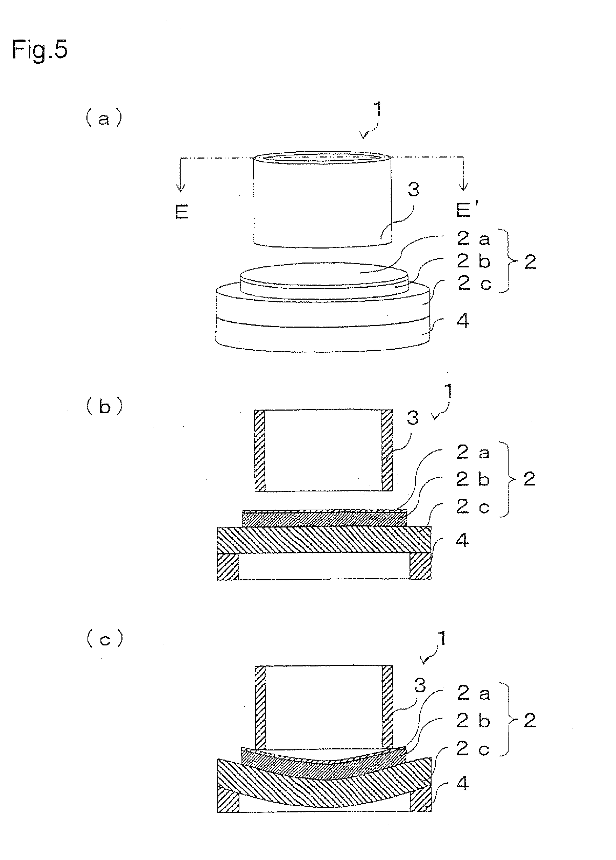

Fig. 5 shows another example of the embodiment of the power generation member of the present invention, in which Fig. 5(a) is a perspective view and Fig. 5(b) is a sectional view taken along lines E-E' of Fig. 5(a). Further, Fig. 5(c) is a sectional view showing a state where a piezoelectric element is pressed by a ring pressing member having a ring pressing face.

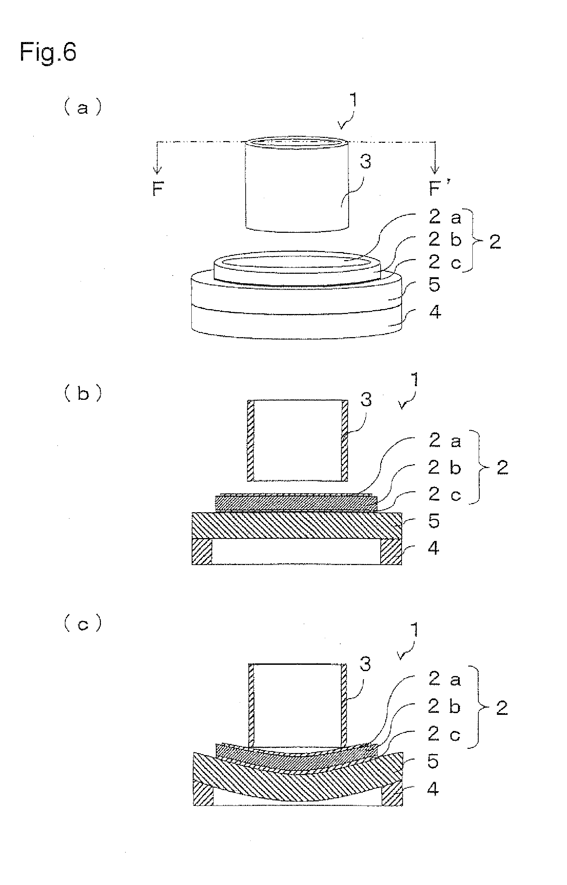

Fig. 6 shows another example of the embodiment of the power generation member of the present invention, in which Fig. 6(a) is a perspective view and Fig. 6(b) is a sectional view taken along lines F-F' of Fig. 6(a). Further, Fig. 6(c) is a sectional view showing a state where a piezoelectric element is pressed by a ring pressing member having a ring pressing face.

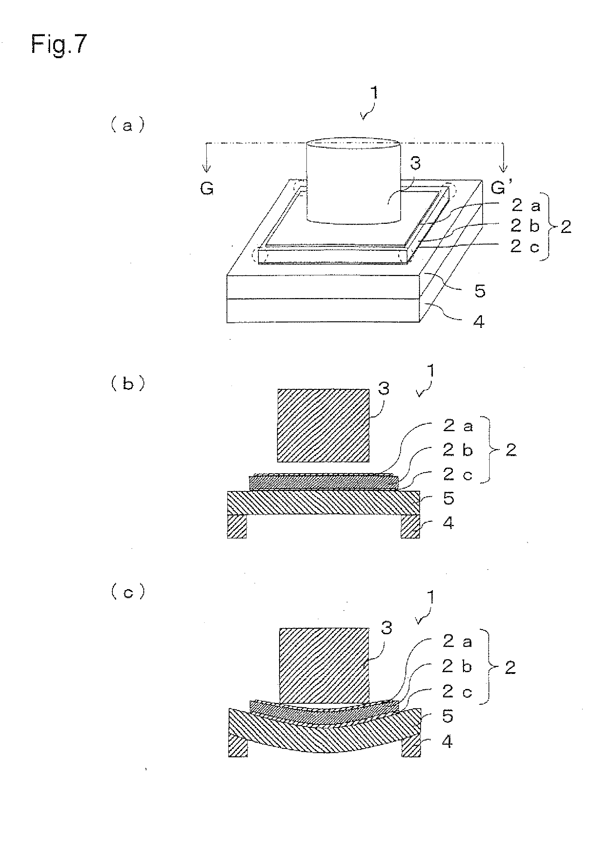

Fig. 7 shows another example of the embodiment of the power generation member of the present invention, in which Fig. 7(a) is a perspective view and Fig. 7 (b) is a sectional view taken along lines G-G' of Fig. 7(a). Further, Fig. 7 (c) is a sectional view showing a state where a piezoelectric element is pressed by a pressing member.

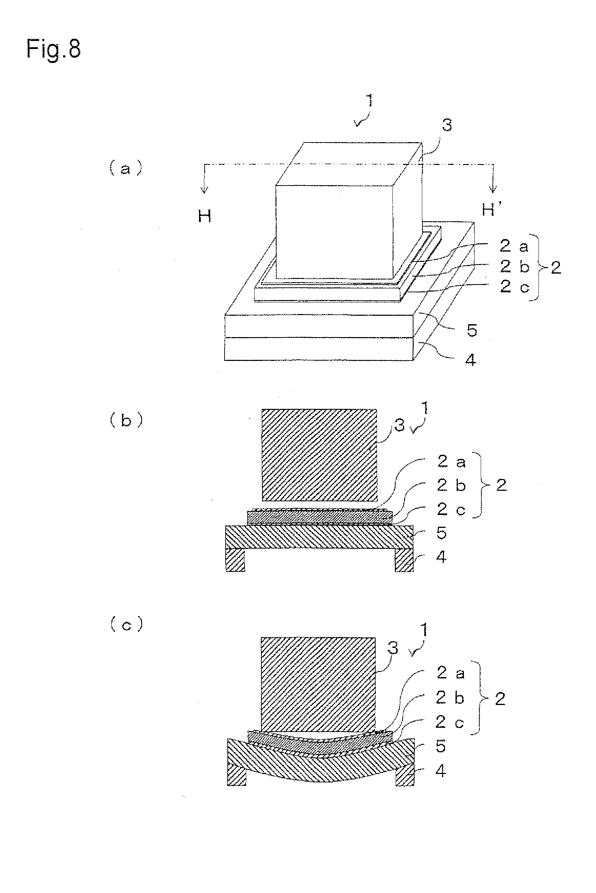

Fig. 8 shows another example of the embodiment of the power generation member of the present invention, in which Fig. 8(a) is a perspective view and Fig. 8(b) is a sectional view taken along lines H-H' of Fig. 8(a). Further, Fig. 8 (c) is a sectional view showing a state where a piezoelectric element is pressed by a pressing member.

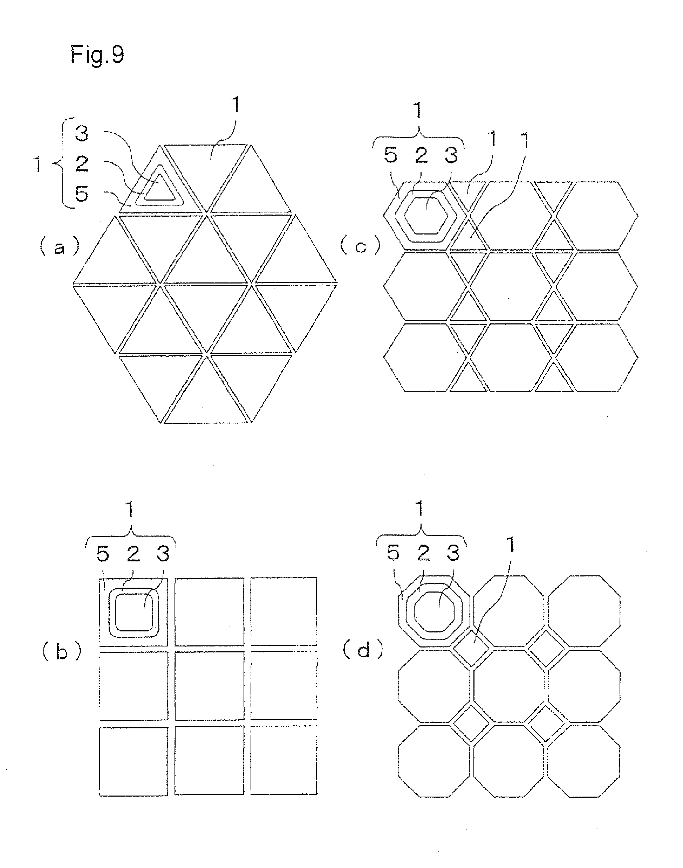

Fig. 9 is schematic views showing alignment examples of the power generation members of the present invention, in which Fig. 9(a) is a combination of triangular members, Fig. 9(b) is a combination of rectangular members, Fig. 9(c) is a combination of hexagonal and triangular members, and Fig. 9(d) is a combination of octagonal and rectangular members.

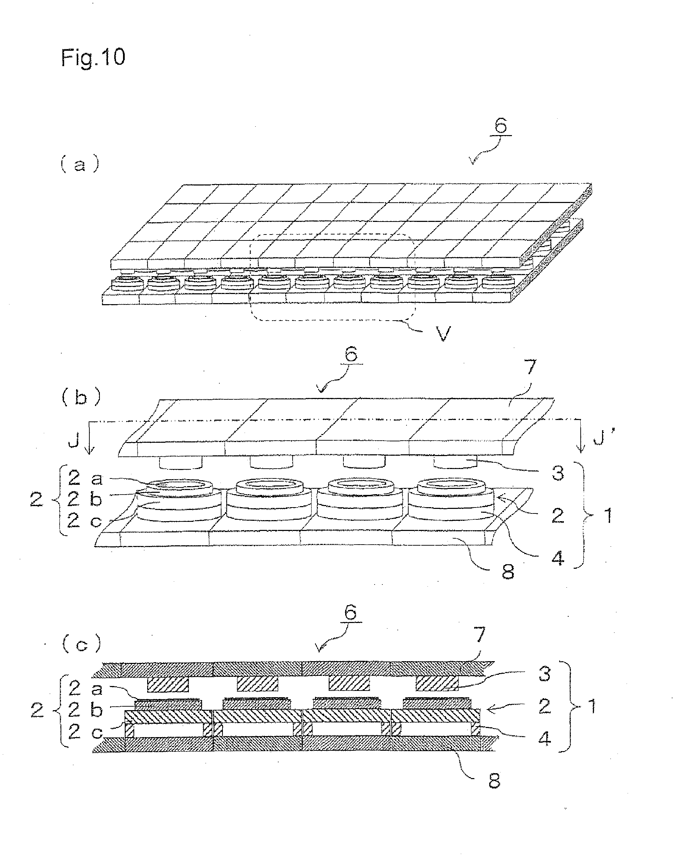

Fig. 10 is an example of the embodiment of the power generation device using the power generation members of the present invention, in which Fig. 10(a) is a perspective view and Fig. 10(b) is an enlarged view of the part V of Fig. 10(a), and Fig. 10(c) is a sectional view taken along lines J-J' of Fig. 10 (b) .

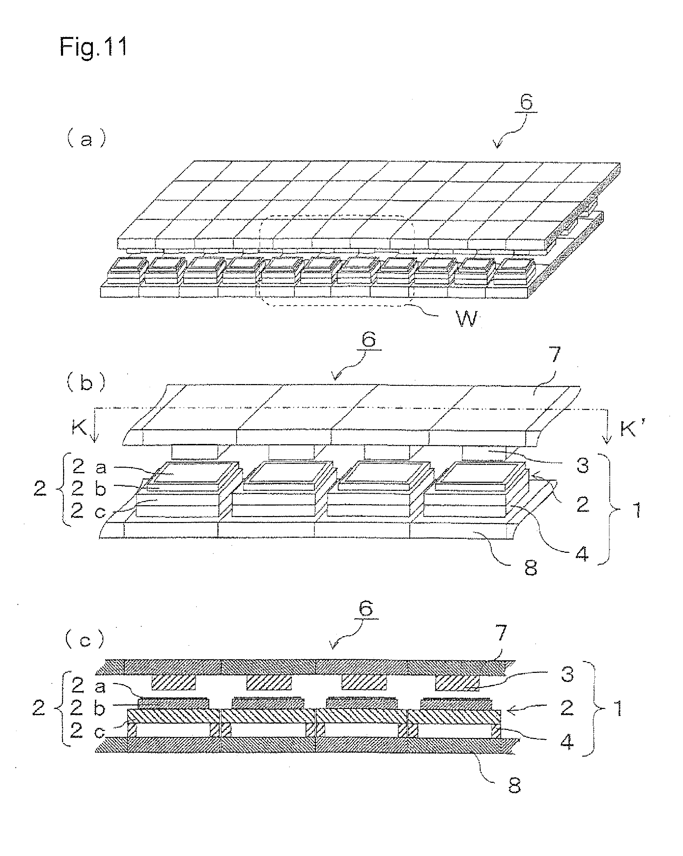

Fig. 11 shows another example of the embodiment of the power generation device using the power generation members of the invention, in which Fig. 11(a) is a perspective view, Fig. 11(b) is an enlarged view of the part W of Fig. 11(a), and Fig. 11(c) is a sectional view taken along lines K-K' of Fig. 11 (b) .

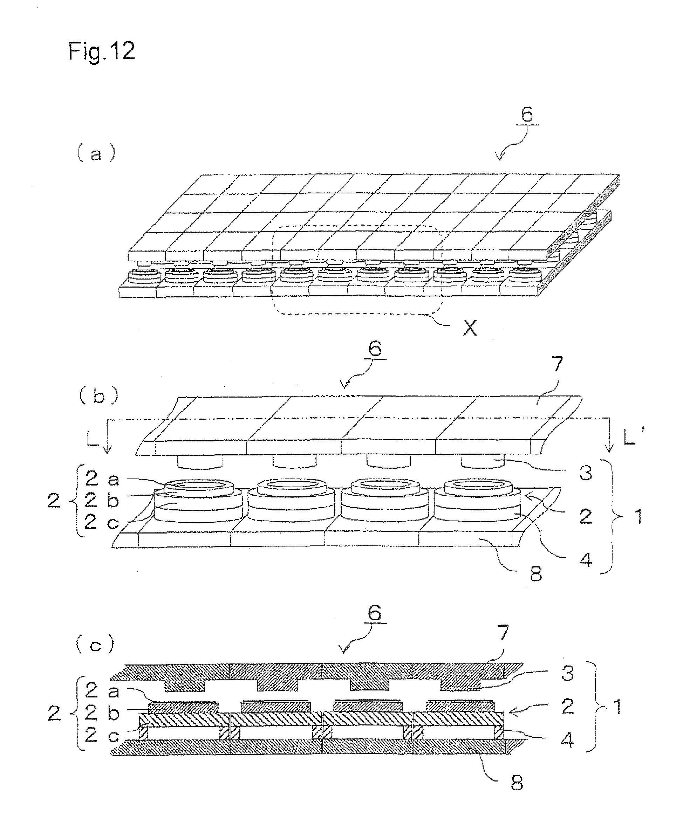

Fig. 12 shows another example of the embodiment of the power generation device using the power generation member of the present invention, in which Fig. 12(a) is a perspective view, Fig. 12(b) is an enlarged view of a part X of Fig. 12(a), and Fig. 12(c) is a sectional view taken along lines L-L' of Fig. 12(b).

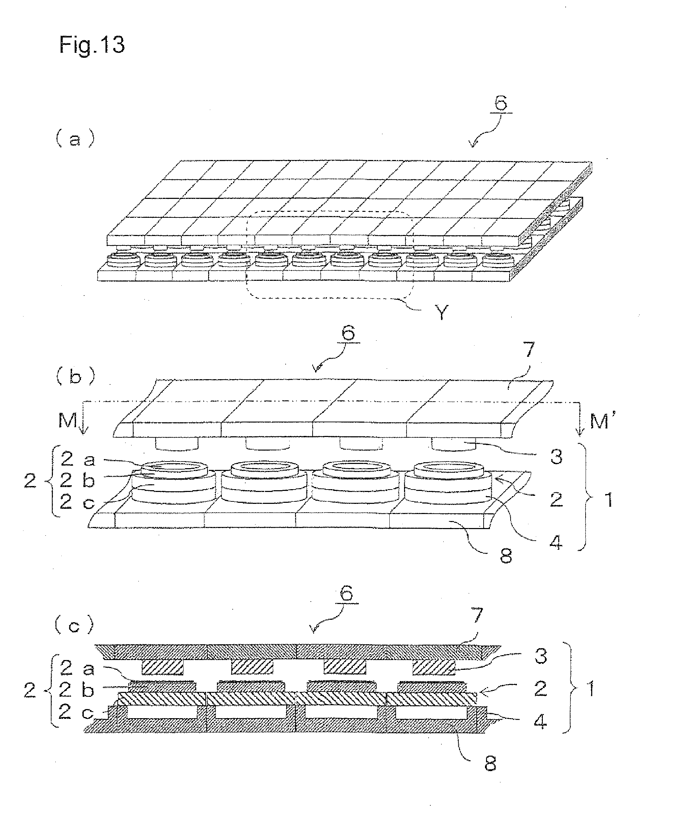

Fig. 13 shows another example of the embodiment of the power generation device using the power generation members of the present invention, in which Fig. 13(a) is a perspective view, Fig. 13(b) is an enlarged view of the part Y of Fig. 13(a), and Fig. 13(c) is a sectional view taken along lines M-M' of Fig. 13(b).

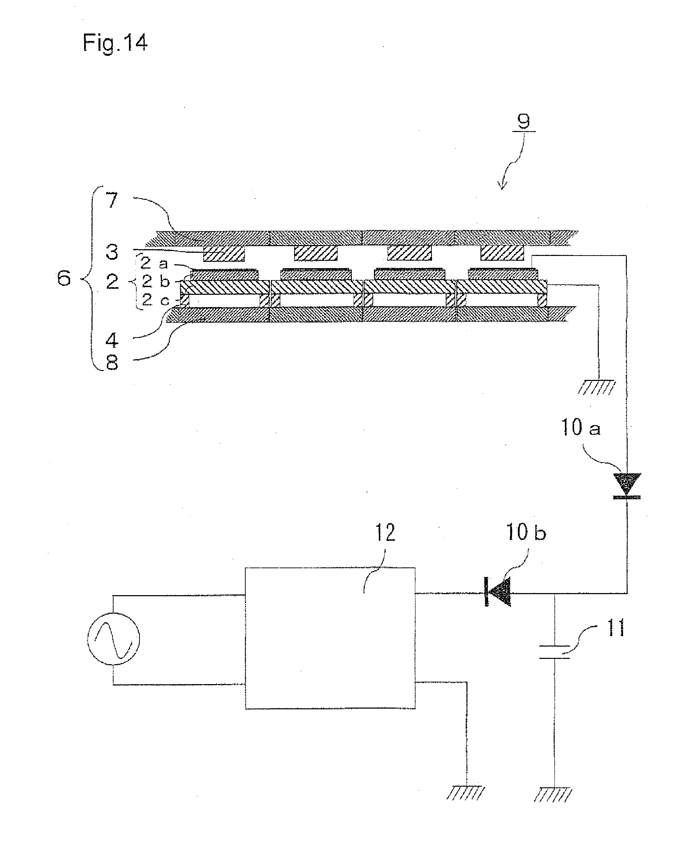

Fig. 14 is a schematic block diagram showing one example of an embodiment of the power generation system using the power generation device of the present invention.

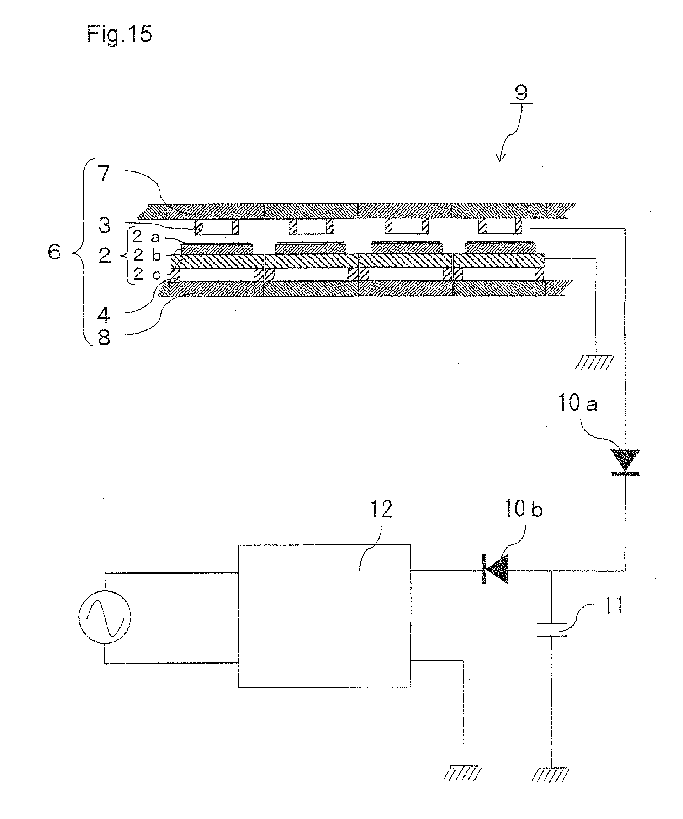

Fig. 15 is a schematic block diagram showing another example of the embodiment of the power generation system using the power generation device of the present invention.

Fig. 16 is a perspective view of a piezoelectric element shown, in which metal electrodes are attached to both ends of a conventional piezoelectric ceramic material.

Fig. 17 shows the flooring material comprising a conventional piezoelectric element, in which Fig. 17(a) is an exploded view of its basic structure, and Fig. 17(b) is a sectional view of the flooring material.

Detailed Description of the Invention

Examples of embodiments of the power generation member, the power generation device using the same and the power generation system of the present invention will be described below. Fig. 1 shows an example of an embodiment of the power generation member of the present invention, in which Fig. 1 (a) is a perspective view and Fig. 1(b) is a sectional view taken along lines A-A' of Fig. 1(a) Further, Fig. 1(c) is a sectional view showing a state where a piezoelectric element is pressed by a pressing member.

A power generation member 1 of the example shown in Fig. 1 comprises a piezoelectric element 2 in which electrodes 2a and 2c are formed on both main faces of a plate-shaped piezoelectric ceramic 2b, a pressing member 3 to press one main face of the piezoelectric element 2, and a support member 4 to support the other main face of the piezoelectric element 2.

The piezoelectric ceramic 2b of the piezoelectric element 2 is a circular and plate-shaped ceramic having piezoelectricity, and may be composed of, for example, any compound having a perovskite structure such as lead zirconate titanate (PZT), lead titanate (PT), barium titanate (BT), bismuth (Bi) lamellar compounds, tungsten bronze compounds, alkali niobate (Nb) compounds.

The electrode 2a is a circular and layered electrode formed on one main face of the piezoelectric ceramic 2b, and the electrode 2c is a circular and plate-shaped electrode formed on the other main face of the piezoelectric ceramic 2b. Since the electrode 2c is a circular and plate-shaped electrode, it can also perform a function of holding the piezoelectric ceramic 2b to which the electrode 2a is formed. Regarding material, the electrodes 2a and 2c are suitably composed of at least one selected from gold, silver, copper, brass and palladium having high electroconductivity.

It is required that the pressing member 3 presses the piezoelectric element 2 in a manner not breaking it, and the support member 4 supports the piezoelectric element 2 in a manner not breaking it. Therefore, they may be composed of a flexible material, for example, at least one selected from austenitic stainless steels such as SUS303, SUS304 and SUS316; aluminum alloys such as 3000 series and 5000 series; rubbers; resins; carbon nanotubes and carbon fiber materials.

It is important that the pressing member 3 has a planar pressing face. When the pressing member 3 has a hemispherical or curved pressing face, the pressed piezoelectric ceramic 2b has a negative strain at a center, but the strain value turns over along a radial direction from the center to an outer rim (an outer circumference), and the pressed piezoelectric ceramic 2b has a positive strain at the outer rim. The generated charge is cancelled due to presence of both positive and negative strains, which results smaller extractable voltage. In contrast, when the pressing member 3 has the planar pressing face, the point where the strain value turns over is shifted toward the outer rim, and it is possible to reduce the cancellation of the generated charge.

It is important that the support member 4 supports the outer rim of the piezoelectric element 2. It becomes possible to allow the piezoelectric ceramic 2b to deform sufficiently so as to produce large strain when the support member 4 supports the outer rim of the piezoelectric element 2. As described above, in the power generation member 1, the support member 4 supports the outer rim (or outer circumference region) of the piezoelectric element 2 and the pressing member 3 presses the piezoelectric element 2 with the planar pressing face at a part inside the support member 4. Therefore, it is possible to reduce the cancellation of the generated charge, as well as to allow the piezoelectric ceramic 2b to deform sufficiently to produce large strain as shown in Fig. 1(c) by pressure energy generated by a walking man or vibration energy generated by a running car and the like. As a result, it is possible to effectively obtain large electricity.

Fig. 2 shows another example of the embodiment of the power generation member of the present invention, in which Fig. 2(a) is a perspective view and Fig. 2(b) is a sectional view taken along lines B-B' of Fig. 2(a). Further, Fig. 2(c) is a sectional view showing a state where a piezoelectric element is pressed by a pressing member.

In a power generation member 1 of the example shown in Fig. 2, an electrode 2a is formed so that a main face of the piezoelectric element 2 is flat and has no bump. Therefore, it is possible to expand a pressing face of a pressing member 3. As above, since the piezoelectric element 2 has the planar main face and the pressing member 3 has the expanded pressing face in the power generation member 1, the point where the strain value turns over shifts toward an outer rim compared to the power generation member 1 of the example shown in Fig. 1. Thus, it is possible to reduce cancellation of the generated charge.

Fig. 3 shows another example of the embodiment of the power generation member of the present invention, in which Fig. 3(a) is a perspective view and Fig. 3(b) is a sectional view taken along lines C-C' of Fig. 3(a). Further, Fig. 3(c) is a sectional view showing a state where a piezoelectric element is pressed by a pressing member.

A power generation member 1 of the example shown in Fig. 3 comprises a piezoelectric element 2 in which layered electrodes 2a and 2c are formed on both main faces of a plate-shaped piezoelectric ceramic 2b, a holding member 5 to hold the piezoelectric element 2, a pressing member 3 to press one main face of the piezoelectric element 2 and a support member 4 to support the other main face of the piezoelectric element 2. Also by such structure, it is possible to extract voltage and to generate electricity.

It is preferable that the holding member 5 is composed of one selected from gold, silver, copper, brass, palladium, SUS (stainless steel), phosphor bronze, copper-titanium alloy, oxygen-free copper, tough-pitch copper and phosphorous-deoxidized copper, which have high electroconductivity.

Fig. 4 shows an example of the embodiment of the power generation member of the present invention, in which Fig. 4(a) is a perspective view and Fig. 4(b) is a sectional view taken along lines D-D' of Fig. 4(a). Further, Fig. 4(c) is a sectional view showing a state where a piezoelectric element is pressed by a ring pressing member having a ring pressing face (or annular pressing face) .

A power generation member 1 of the example shown in Fig. 4 is as same as that of Fig. 1 in its structure and the like, except the pressing member 3 has the ring pressing face or the pressing member 3 itself has a ring shape. Therefore, overlapping description is omitted. As shown in the example of Figs. 4(a) and 4(b), the power generation member 1 is such that a support member 4 supports an outer rim of the piezoelectric element 2, and the pressing member 3 presses the piezoelectric element 2 at a part inside the support member 4 with a ring pressing face. Therefore, it is possible to reduce cancellation of the generated charge, as well as to allow a piezoelectric ceramic 2b to deform sufficiently to produce large strain as shown in Fig. 4(c) by pressure energy generated by a walking man or vibration energy generated by a running car and the like. As a result, it is possible to effectively obtain large electricity.

When the pressing member 3 had a hemispherical or curved pressing face and pressed a center part of the piezoelectric element 2, the pressed piezoelectric ceramic 2b would have a negative strain at a center, but the strain value would turn over along a radial direction from the center to an outer rim and the pressed piezoelectric ceramic 2b would have a positive strain at the outer rim. In such case, the generated charge is cancelled due to presence of both positive and negative strains, which results smaller extractable voltage. In contrast, since the pressing member 3 has the ring pressing face, the piezoelectric element 2 is pressed not around its center part but its outer rim, and the point where the strain value turns over is shifted toward the outer rim of the piezoelectric element 2. Thus, it is possible to reduce cancellation of the generated charge. The ring pressing face of the pressing member 3 is not limited as long as it presses the piezoelectric element 2 not around the center part but at a part inside the support member 4.

When the pressing member 3, which constitutes the power generation member 1, has the ring pressing face, it is possible to reduce a weight compared to one having a planar pressing face. Further, when the pressing member 3 itself has a ring shape, it is possible to reduce a weight of the power generation member 1. As a result, it is possible to reduce a weight of a power generation device where a plurality of the power generation members 1 are arrayed in a plane. The reduction in weight of the power generation device also makes it possible to reduce burden on carrying it. The pressing member 3 having the ring pressing face is not limited to the example in which the pressing member 3 itself has a ring shape as a whole, but may have a concave at a center part of the pressing face so that the pressing face has a ring shape. In this case, it is possible to reduce at least the weight corresponding to the concave.

Fig. 5 shows another example of the embodiment of the power generation member of the present invention, in which Fig. 5(a) is a perspective view and Fig. 5(b) is a sectional view taken along lines E-E' of Fig. 5(a). Further, Fig. 5(c) is a sectional view showing a state where a piezoelectric element is pressed by a ring pressing member having a ring pressing face.

In a power generation member 1 of the example shown in Fig. 5, an electrode 2a is formed so that a main face of the piezoelectric element 2 is flat and has no bump. Therefore, it is possible to enlarge a diameter of the ring pressing member 3 having the ring pressing face so as to shift the pressing point toward an outer rim of the piezoelectric element 2. As above, since the piezoelectric element 2 has the flat main face and the ring pressing member 3 having the ring pressing face is enlarged in diameter of the pressing face so as to shift the pressing point toward the outer rim of the piezoelectric element 2, the point where the strain value turns over is shifted toward the outer rim compared to the power generation member 1 of the example shown in Fig. 4. Thus, it is possible to reduce cancellation of the generated charge.

Fig. 6 shows another example of the embodiment of the power generation member of the present invention, in which Fig. 6(a) is a perspective view and Fig. 6(b) is a sectional view taken along lines F-F' of Fig. 6(a). Further, Fig. 6(c) is a sectional view showing a state where a piezoelectric element is pressed by a ring pressing member having a ring pressing face.

A power generation member 1 of the example shown in Fig. 6 comprises a piezoelectric element 2 in which layered electrodes 2a and 2c are formed on both main faces of a plate-shaped piezoelectric ceramic 2b, a holding member 5 to hold the piezoelectric element 2, a ring pressing member 3 having a ring pressing face to press one main face of the piezoelectric element 2, and a support member 4 to support the other main face of the piezoelectric element 2. Also by such structure, it is possible to extract voltage and to generate electricity. It is preferable that the holding member 5 is composed of one selected from gold, silver, copper, brass, palladium, SUS (stainless steel), phosphor bronze, copper-titanium alloy, oxygen-free copper, tough-pitch copper and phosphorous-deoxidized copper, which have high electroconductivity.

The examples shown in Figs. 1 to 6, which are the embodiment of the present invention, are combinations of the pressing member 3, piezoelectric element 2, holding member 5 and support member 4, all of which have a circular shape in a plan view. However, the embodiment may be a combination of the following shapes.

Fig. 7 shows another example of the embodiment of the power generation member of the present invention, in which Fig. 7(a) is a perspective view and Fig. 7(b) is a sectional view taken along lines G-G' of Fig. 7(a). Further, Fig. 7 (c) is a sectional view showing a state where a piezoelectric element is pressed by a pressing member.

In a power generation member 1 of the example shown in Fig. 7, the pressing member 3 has a circular shape in a plan view, and the piezoelectric element 2 and a holding member 5 each have a rectangular shape in a plan view.

When the piezoelectric element 2 has a polygonal shape such as rectangular shape in a plan view, it is preferable that each corner of the piezoelectric ceramic 2b of the piezoelectric element 2, which is shown by dotted line circles in Fig. 7(a), has an arc shape in a plan view, i.e. a rounded shape. As a result, it is possible to reduce localized concentration of stress caused by pressure energy generated by a walking man or vibration energy generated by a running car and the like on the power generation member 1, and thus to prevent breakage of the piezoelectric ceramic 2b and holding member 5.

Fig. 8 shows another example of the embodiment of the power generation member of the present invention, in which Fig. 8(a) is a perspective view and Fig. 8(b) is a sectional view taken along lines H-H' of Fig. 8(a). Further, Fig. 8(c) is a sectional view showing a state where a piezoelectric element is pressed by a pressing member.

A power generation member 1 of the example shown in Fig. 8 is a combination of a pressing member 3, piezoelectric element 2 and holding member 5, all of which have a rectangular shape in a plan view.

As above, since the pressing member 3, piezoelectric element 2 and holding member 5 have the same shape in a plan view, they can be easily aligned and it is possible to reduce the production cost. Also, since it is easy to allow distribution of given pressure and caused stress to be symmetrical in a plan view, it is possible to prevent bias of power generation so as to improve efficiency. Further, it is possible to prevent partial breakage so as to improve durability. It will be appreciated that these members may have the other shapes such as a triangular, hexagonal and octagonal shape and a combination of them.

Fig. 9 is schematic views showing alignment examples of the power generation members of the present invention, in which Fig. 9(a) is a combination of triangular members, Fig. 9(b) is a combination of rectangular members, Fig. 9(c) is a combination of hexagonal and triangular members, and Fig. 9(d) is a combination of octagonal and rectangular members.

In Fig. 9, holding members 5, piezoelectric elements 2 and pressing members 3 are shown only in the power generation member 1 located at the top left of each schematic view of Fig. 9(a) to Fig. 9(d), and they are omitted in the others. As shown in the schematic views Fig. 9(a) to Fig. 9(d), it is preferable that the power generation members 1 of the present invention have a triangular, rectangular, hexagonal or octagonal shape in a plan view.

In the examples shown in Fig. 9, the power generation members 1 of the present invention has a shape corresponding to that of the holding members 5 in a plan view, which have the largest external shape in a plan view. When the power generation members 1 do not comprise the holding member 5 as shown in Figs. 1 and 2, in which the electrodes 2c are plate-shaped electrodes and have a function of holding the piezoelectric elements 2b on which the electrodes 2a are formed, they have a shape corresponding to that of the electrode 2c.

When the power generation members 1 have a combination of triangular or rectangular shapes in a plan view as shown in the schematic views of Figs. 9(a) and 9(b), or have a combination of hexagonal and triangular shapes or octagonal and rectangular shapes in a plan view as shown in the schematic views of Figs. 9(c) and 9(d), it is possible to array a plurality of the power generation members 1 closely in a plane with little space between them, and thus to effectively obtain large electricity.

According to the power generation member 1 of the present invention, it is desirable that the pressing member 3 may be composed of a material having a lower hardness than that of the support member 4. Since the pressing member 3 is composed of a material having lower hardness than that of the support member 4, even when the power generation member 1 is subjected to large pressure energy generated by a walking man or large vibration energy generated by a running car or the like, the pressing member 3 absorbs and buffers such large pressure or vibration energy, and the support member 4 supports the piezoelectric element 2 so as to prevent it from excess deformation. As a result, it is possible to prevent the piezoelectric ceramic 2b of the piezoelectric element 2 from breakage.

Specifically, preferable combinations are such that the pressing member 3 is composed of at least one selected from rubbers, resins, carbon nanotubes and carbon fiber materials, and the support member 4 is composed of at least one metal selected from austenitic stainless steels such as SUS303, SUS304 and SUS316; and aluminum alloys such as 3000 series and 5000 series. When the pressing member 3 and support member 4 are both composed of rubber, it is preferable that difference of hardness between the pressing member 3 and support member 4 is A5/15/S or more based on ISO 7619-2004.

According to the power generation member 1 of the present invention, it is preferable that the piezoelectric ceramic 2b is composed of lead zirconate titanate. Since lead zirconate titanate has high ferroelectricity, which is one of the characteristics affecting power generation capacity, it is possible to obtain larger electricity by use of the piezoelectric ceramic 2b composed of lead zirconate titanate.

As lead zirconate titanate having high ferroelectricity, particularly preferable are materials having high piezo-

electric constant $d_{31}$. One example is a ceramic comprising a main component represented by the composition formula of $PbZrO_3$-$PbTiO_3$-$Pb(Zn_{1/3}Sb_{2/3})O_3$, and further comprises bismuth (Bi) and iron (Fe) in a range of 5 mass% or more and 15 mass% or less in terms of $BiFeO_3$. Another example is a ceramic comprising a main component which is composed of 100 parts by mass of a component represented by the composition formula of $Pb_{1-x-y}Sr_xBa_y(Zn_{1/3}Sb_{2/3})_a$ $(Ni_{1/2}Te_{1/2})_bZr_cTi_{1-a-b-c}O_3$ where molar ratios of x, y, a, b and c satisfy $0 \leq x \leq 0.12$, $0 \leq y \leq 0.12$, $0 < x+y$, $0.05 \leq a \leq 0.12$, $0 \leq b \leq 0.015$ and $0.43 \leq c \leq 0.52$, and 0.2 to 1.2 parts by mass in total of PbO and $Nb_2O_5$ which are equal to each other in molar ratio, and further comprising less than 0.6 mol% of magnesium (Mg) with respect to the main component. Another example is a ceramic comprising 100 parts by mass of a component represented by the composition formula of $(Pb_{(1-x)}A_x)_z$ $(Zr_{(1-y)}Ti_y)O_3$ where A represents at least one selected from Ba, Sr and Ca, and molar ratios of x, y and z satisfy $0.01 \leq x \leq 0.10$, $0.43 \leq y \leq 0.50$ and $0.98 \leq z \leq 1.07$, and further comprises 0.05 to 2 parts by mass of Nb in terms of $Nb_2O_5$, and 0.01 to 0.5 parts by mass of Zn in terms of ZnO.

Materials having high piezoelectric constant $d_{33}$ may also be used. One preferable example is a ceramic represented by the composition formula of $Pb_{1-x-y}Sr_xBa_y(Zn_{1/3}Sb_{2/3})_aZr_bTi_{1-a-b}O_3$ where molar ratios of x, y, a and b satisfy $0 \leq x \leq 0.14$, $0 \leq y \leq 0.14$, $0.04 \leq x + y$, $0.01 \leq a \leq 0.12$ and $0.43 \leq b \leq 0.58$. When the molar ratios are within these ranges, it is possible to make attenuation rate of piezoelectric constant $d_{33}$ very low even after repetitive loading.

According to the power generation member 1 of the present invention, it is preferable that the piezoelectric ceramic 2b has a composition comprising potassium-sodium-lithium niobate as a main component, and further comprising calcium titanate and bismuth ferrite. When the piezoelectric ceramic 2b comprises potassium-sodium-lithium niobate as a main component, and further comprises calcium titanate and bismuth ferrite, discontinuation called second-order phase transition hardly occur, which is phase transformation from a ferroelectric phase at lower temperature to that at higher temperature depending on change rates of resonant frequency, antiresonant frequency and piezoelectric constant $g_{33}$ with respect to temperature in a range of -40°C to +150°C. Therefore, it is possible to stabilize piezoelectric properties. Also, since it allows lead-free composition, the power generation member 1 can be eco-friendly. A main component of the piezoelectric component 2 denotes a component which accounts for 50 mass% or more of all components, 100 mass% in total.

Fig. 10 is an example of the embodiment of the power generation device using the power generation members of the present invention, in which Fig. 10(a) is a perspective view and Fig. 10(b) is an enlarged view of the part V of Fig. 10(a), and Fig. 10(c) is a sectional view taken along lines J-J' of Fig. 10(b).

In a power generation device 6 of the example shown in Fig. 10, a plurality of power generation members 1 are arrayed in a plane, plate-shaped first covering members 7 hold respective pressing members 3, and plate-shaped second covering members 8 hold respective support members 4. It is preferable that the pressing members 3 and support members 4 are jointed or connected to the respective first and second covering members 7 and 8 by use of adhesive or connectors such as screws for holding them.

According to the power generation device 6 of the example shown in Fig. 10, the first and second covering members 7 and 8 hold the respective pressing members 3 and support members 4, and the power generation members 1 of the present invention, which has a high power generating capacity, are arrayed in a plane. Therefore, it is possible to effectively use pressure energy generated by a walking man and vibration energy generated by a running car or the like for power generation. Also, the pressing members 3 and support members 4 are respectively held by the first and second covering members 7 and 8 so that vibration energy is transmitted not to a specific power generation member 1 but to a plurality of the power generation members 1 in a dispersed manner. Therefore, the power generation members 1 are resistant to damage, and thus can be used for a long period.

When the power generation members 1 of the present invention, which constitutes the power generation device 6 of the present invention, have a triangular, rectangular, hexagonal or octagonal shape in a plan view, it is possible to combine a plurality of the power generation members 1 to array them closely in a plane. Therefore, it is possible to effectively use pressure energy generated by a walking man and vibration energy generated by a running car or the like on the power generation device 6 for power generation. The power generation device 6 composed of a plurality of the power generation members 1 may also have various shapes in a plan view such as triangular, rectangular, hexagonal and octagonal shape, and it is possible to combine a plurality of the power generation devices 6 to array them closely in a plane similarly.

Fig. 11 shows another example of the embodiment of the power generation device using the power generation members of the invention, in which Fig. 11 (a) is a perspective view, Fig. 11 (b) is an enlarged view of the part W of Fig. 11(a), and Fig. 11(c) is a sectional view taken along lines K-K' of Fig. 11(b).

In a power generation device 6 of the example shown in Fig. 11, pressing members 3, piezoelectric elements 2 and the like of the power generation members 1 have a rectangular shape in a plan view, a plurality of the power generation members 1 are arrayed closely in a plane, pressing members 3 are held by respective plate-shaped first covering members 7, and support members 4 are held by respective plate-shaped second covering members 8. While the first and second covering members 7 and 8 have a rectangular shape in a plan view, the power generation members 1 may also have a triangular, rectangular, hexagonal or octagonal shape in a plan view or a combination of them, so as to array the power generation members 1 closely in a plane with little space between them. Therefore, it is possible to form the power generation device 6 to various shapes, as well as to obtain large electricity effectively.

Fig. 12 shows another example of the embodiment of the power generation device using the power generation member of the present invention, in which Fig. 12(a) is a perspective view, Fig. 12(b) is an enlarged view of a part X of Fig. 12(a), and Fig. 12(c) is a sectional view taken along lines L-L' of Fig. 12(b).

In a power generation device 6 of the example shown in Fig. 12, pressing members 3 are integrally formed with respective first covering members 7. Since the pressing members 3 are not simply in contact with the first covering members 7, but formed integrally with them, relative position between piezoelectric elements 2 and the pressing members 3 does not change. Also, compared to the case where the pressing members 3 are joined or connected to the first covering members 7, failure of adhesion or loosing of connectors such as screws does not occur even by repetitive power generation by use of pressure energy generated by a walking man or vibration energy generated by a running car and the like. As a result, it is possible to effectively obtain large electricity for a long period.

Fig. 13 shows another example of the embodiment of the power generation device using the power generation members of the present invention, in which Fig. 13(a) is a perspective view, Fig. 13 (b) is an enlarged view of the part Y of Fig. 13(a), and Fig. 13(c) is a sectional view taken along lines M-M' of Fig. 13(b).

In the power generation device 6 of the example shown in Fig. 13, support members 4 are formed integrally with respective second covering members 8. Since the support members 4 are not simply in contact with the second covering members 8, but formed integrally with them, relative position between piezoelectric elements 2 and the support members 4 does not change. Also, compared to the case where the support members 4 are joined or connected to the first covering members 7, failure of adhesion or loosing of connectors such as screws does not occur even by repetitive power generation by use of pressure energy generated by a walking man or vibration energy generated by a running car and the like. As a result, it is possible to effectively obtain large electricity for a long period. Also, since the support members 4 are formed integrally with the respective second covering members 8, it is possible to omit a joining or connecting step.

It is also preferable that a power generation device 6 is composed of pressing members 3 integrally formed with respective first covering members 7, support members 4 integrally formed with respective second covering members 8 and piezoelectric elements 2, since it is successful in obtaining the same effects as above. Also, in the examples shown in Figs. 12 and 13, the first covering member 7 and the second covering member 8 are independently integrated with a respective pressing member 3 or a respective support member 4. However, it is also preferable that each of the first covering members 7 and the second covering members 8 is integrated with a plurality of the pressing members 3 or a plurality of the support members 4.

Figs. 14 and 15 are schematic structural views showing an example of the embodiment of the power generation system using the power generation device of the present invention.

A power generation system 9 of the example shown in Figs. 14 and 15 comprises a power generation device 6 of the present invention and a DC-AC converter 12 connected via a circuit comprising diodes 10a and 10b and a capacitor 11. Regarding pressing members 3 of the power generation members 1 constituting power generator 6 of the present invention, Fig. 14 shows pressing members 3 having a planar pressing face, and Fig. 15 shows pressing members 3 having a ring pressing face.

In the power generation system 9, the pressing members 3 having a planar pressing face or the pressing members 3 having a ring pressing face, which are held by first covering members 7, presses piezoelectric elements 2 by pressure energy generated by a walking man or vibration energy generated by a running car and the like. Support members 4 held by second covering members 8 support outer rims of the piezoelectric elements 2. Therefore, piezoelectric ceramics 2b are deformed to have strain, and voltages generated by the strain are accumulated to a capacitor 11 through the diode 10a as electric charge. Then, the charge accumulated in the capacitor 11 is extracted through the diode 10b and converted to alternated current with the DC-AC converter 12. Accordingly, the energy can be extracted as electricity.

When the power generation system 9 of the invention is such that the power generation device 6 of the present invention is placed on a floor, stairs, road, bridge or parking lot or under a railway track, it is possible to generate electricity by use of pressure energy generated by a walking man or vibration energy generated by a running car and the like. Therefore, the power generation system can be an effective measure for energy conservation as well as a clean system with no $CO_2$ emissions.

Also, when the power generation device 6 of the present invention, which is provided in the power generation system 9 of the present invention, has a triangular, rectangular, hexagonal or octagonal shape in a plan view, it is possible to array a plurality of the power generation devices 6 closely in a plane with little space between them, and thus to obtain large electricity effectively. It is also possible to change color of the first covering members 7 or to combine the power generation devices 6 of various shapes, so as to obtain the power generation system 9 which is suitable for decoration.

Next, an example of a method for producing the power generation member of the present invention will be described.

First, an example in which the piezoelectric ceramic 2b is composed of lead zirconate titanate will be described. As starting materials, powders of lead oxide ($Pb_3O_4$), zirconium oxide ($ZrO_2$), titanium oxide ($TiO_2$), strontium carbonate ($SrCO_3$), barium carbonate ($BaCO_3$), zinc oxide (ZnO), antimony oxide ($Sb_2O_3$), nickel oxide (NiO) and tellurium oxide ($TeO_2$) are measured out and mixed to obtain a material blend. The material blend is charged into a ball mill with water as solvent, and mixed and ground for 20 hours or more and 30 hours or less, so as to obtain slurry. Zirconia -based balls may be used for the mixing and grinding by a ball mill. As needed, lead oxide (PbO) and niobium oxide ($Nb_2O_5$) may be measured out and mixed in addition to the above starting materials.

After dewatered and dried, the obtained slurry is calcined under air atmosphere at a temperature of 850˚C or more and 900˚C or less for a holding time of 1 hour or more and 3 hours or less, so as to obtain a calcined powder. Next, a certain amount of magnesium oxide ($MgCO_3$) powder is added to the obtained calcined powder so that a content of magnesium (Mg) is 0.6 mol% or less with respect to the calcined powder. The mixture is ground and mixed, so as to obtain a powder mix. The powder mix is processed to be slurry, and a compact of a certain shape such as disk, triangular, rectangular, hexagonal or octagonal shape is obtained by tape casting or extrusion. Alternatively, the slurry of the powder mix is processed to be granule by spray drying, and the compact of a certain shape may be formed by dry pressing. The compact is fired under air atmosphere or oxygen atmosphere at 1,100˚C or more and 1,300˚C or less, so that a piezoelectric ceramic 2b of a sintered body can be obtained.

After dewatered and dried, the obtained slurry is calcined under air atmosphere at a temperature of 850˚C or more and 900˚C or less for a holding time of 1 hour or more and 3 hours or less, so that a calcined powder comprising a main component represented by the composition formula of $PbZrO_3$-$PbTiO_3$-$Pb(Zn_{1/3}Sb_{2/3})O_3$ is obtained. Next, a certain amount of bismuth oxide ($Bi_2O_3$) powder and iron oxide ($Fe_2O_3$) powder are added and mixed to the obtained calcined powder, so as to obtain a powder mix. The powder mix is processed to be slurry, and a compact of a certain shape such as disk, triangular, rectangular, hexagonal or octagonal shape is obtained by tape casting or extrusion. Alternatively, the slurry of the powder mix is processed to be granule by spray drying, and the compact of a certain shape is formed by dry pressing. The compact is fired under air atmosphere or oxygen atmosphere at 1,000˚C or more and 1,100˚C or less, so that the piezoelectric ceramic 2b can be obtained.

Further, an example in which the piezoelectric ceramic 2b comprises potassium-sodium-lithium niobate as a main component, and further comprises calcium titanate and bismuth ferrite, will be described. As starting materials, powders of potassium carbonate ($K_2CO_3$), sodium carbonate ($Na_2CO_3$), lithium carbonate ($Li_2CO_3$), calcium carbonate ($CaCO_3$), niobium oxide ($Nb_2O_5$), titanium oxide ($TiO_2$) and iron oxide ($Fe_2O_3$) are measured out and mixed to obtain a material blend. For example, the starting materials may be measured out so that the piezoelectric ceramic 2b has the composition formula of (1-a-b) $(K_xNa_yLi_{1-x-y})NbO_3$+$aCaTiO_3$+$bBiFeO_3$ where molar ratios of x, y, a, b and c satisfy $0 < a \le 0.16$, $0 < b \le 0.1$, $0 \le x \le 0.19$ and $0.79 < y < 1$.

Next, the material blend is charged into a ball mill with 2-propanol (isopropanol) as solvent, and mixed and ground for 15 hours or more and 25 hours or less, so as to obtain slurry. Zirconia-based balls may be used for the mixing and grinding by a ball mill.

After dewatered and dried, the obtained slurry is calcined under air atmosphere at a temperature of 900˚C or more and 1,000˚C or less for 3 hours, so as to obtain a calcined powder. Subsequently, the calcined powder is ground with a ball mill again, a binder such as polyvinyl alcohol (PVA) is added to the calcined powder to be slurry, and the slurry is dried by spray drying so as to obtain granule.

Next, the obtained granule is processed by dry pressing at a pressure of 200 MPa, so as to prepare a compact of a certain shape. After degreasing as needed, the obtained compact is fired under air atmosphere, for example, at 1,000˚C or more and 1,250˚C or less, so that the piezoelectric ceramic 2b can be obtained.

Onto one main face of the piezoelectric ceramic 2b obtained by any one of the above production methods, paste composed of, for example, at least one selected from gold, silver, copper and palladium is applied by a known method such as screen printing or dipping, and is heat-treated so as to form the electrode 2a. Next, a brass plate body is adhered onto the other main face of the piezoelectric ceramic 2b with an adhesive such as epoxy adhesive, so as to form the electrode 2c. Then, direct electric field of 3 kV/mm or more and 7 kv/mm or less is applied to it in silicone oil at a temperature of 70˚C or more and 90˚C or less for 10 min or more and 30 min or less, so as to polarize the electrode 2c to be minus and the electrode 2a to be plus. Accordingly, the piezoelectric element 2 of the example shown in Fig. 1, Fig. 2, Fig. 4 or Fig. 5 can be obtained.

Alternatively, onto both main faces of the piezoelectric ceramic 2b obtained by any one of the above production methods, paste composed of, for example, at least one selected from gold, silver, copper and palladium is applied by a known method such as screen printing or dipping, and is heat-treated so as to form the electrodes 2a and 2c. Then, direct electric field of 3 kV/mm or more and 7 kV/mm or less is applied to it in silicone oil at a temperature of 70˚C to 90˚C for 10 to 30min, so as to polarize the electrode 2c to be minus and the electrode 2a to be plus. After the polarization, it is adhered onto a brass holding member 5 having high electroconductivity with an acrylic resin adhesive. Accordingly, the piezoelectric element 2 of the examples shown in Fig. 3, Fig. 6, Fig. 7 or Fig. 8 can be obtained.

Then, the piezoelectric elements 2 obtained by any one of the above methods, the support members 4 to support the piezoelectric elements 2 at an outer rim, the pressing members 3 to press with a planar pressing face or the pressing members 3 to press with a ring pressing face at a part inside the support members 4 are placed to predetermined positions, so that the power generation member 1 of the present invention can be obtained.

Further, a plurality of the power generation members 1 of the present invention are arrayed in a plane, the pressing members 3 are held by the respective first covering members 7 and the support members 4 are held by the respective second covering members 8. Thus, the power generation device 6 of the present invention can be obtained.

When the first and second covering members 7 and 8 have a triangular, rectangular, hexagonal or octagonal shape in a plan view, the power generation members 1 may be formed to have a triangular, rectangular, hexagonal or octagonal shape, in order to fit them.

Further, the DC-AC converter 12 is connected to the power generation device 6 of the present invention via the circuit comprising the diodes 10a and 10b and capacitor 11. Thus, the power generation system 9 of the present invention can be obtained.

EXAMPLES

Examples of the present invention will be described below. However, the present invention is not limited to these Examples.

Example 1

First, layered electrodes 2a mainly composed of silver were formed on both main faces of a piezoelectric ceramic 2b composed of a disk lead zirconate titanate having 25 mm diameter and 0.25 mm thickness. Then, direct electric field of 5 kV/mm was applied for 30 min in silicon oil at 90˚C, so as to polarize the electrode 2c to be minus and the electrode 2a to be plus. A plate-shaped electrode 2c of a brass disk having 35 mm diameter and 0.3 mm thickness was adhered thereon with an acrylic resin adhesive, so that a piezoelectric element 2 as shown in Fig. 1 was formed.

Next, as for the pressing member to press one main face of the piezoelectric element 2, a pressing member having a spherical pressing face and pressing members 3 having a planar and ring pressing face were prepared. As for the support member to support the other main face of the piezoelectric element 2, a support member to support an entire face of the piezoelectric element 2 and a support member 4 to support an outer rim of the piezoelectric element 2 were prepared. Next, power generation members having a combination shown in Table 1 were prepared from the piezoelectric element 2 and the prepared pressing members and support members, and a 1 MΩ resistance is connected to each power generation device to form a circuit.

Each pressing member was attached to a precision universal tester (AUTOGRAPH (registered trademark) AGS-J, manufactured by Shimadzu Corp.). The piezoelectric element 2 was pressed at a rate of 100 mm/min, and a load on the piezoelectric element 2 was measured every 0.05 sec with the precision universal tester. At the same time, voltage across the resistance and resistance value were detected every 0.05 sec with a digital electrometer (R8252, manufactured by Advantest Corp.). Then, electric energy at each time was calculated from the voltages and resistances detected in a period from the start of loading to 40 N, and the sum thereof was obtained as total electric energy. The total electric energy was shown as a relative value with respect to a total electric energy of sample No. 1 as 1, which was the power generation member where the pressing face is planner and the support member supports the other main face of the piezoelectric element 2 at the entire face. The results are shown in Table 1.

Table 1

| Sample No. | Shape of piezoelectr ic element 2 | Position of supporting piezoelectric element 2 | Shape of pressing face | Relative value with respect to total electric energy of *No. 1 |
|---|---|---|---|---|
| *1 | Disk | Entire face | Planar | 1 |
| *2 | Disk | Outer rim | Spherical | 10 |
| 3 | Disk | Outer rim | Planar | 100 |
| 4 | Disk | Outer rim | ring | 100 |
| *Out of the scope of the present invention | | | | |

As apparent from the results shown in Table 1, in the power generation member of sample No. 1, where the pressing member had the planar pressing face and the support member supported the entire face of the piezoelectric element 2, it was impossible to deform the piezoelectric ceramic 2b sufficiently since the support member support the entire face of the piezoelectric element 2. Therefore, the strain was small and the total electric energy was low.

Sample No. 2 was the power generation member where the pressing member had a spherical pressing face and the support member 4 supported the outer rim of the piezoelectric element 2. Since the support member 4 supported the outer rim of the piezoelectric element 2, it was possible to deform the piezoelectric ceramic 2b more than sample No. 1. However, while the pressed piezoelectric ceramic 2b had a negative strain at a center, the strain value turned over along a radial direction from the center to the outer rim, and the pressed piezoelectric ceramic 2b had a positive strain at the outer rim. Since the generated charge was cancelled due to presence of both positive and negative strains, the total electric energy remained at 10 times as much as that of sample No. 1.

In contrast, sample No. 3 was the Example of the present invention where the pressing member 3 had the planar pressing face and the support member 4 supported the outer rim of the piezoelectric element 2. Since the support member 4 support the outer rim of the piezoelectric element 2, and the pressing member 3 pressed the piezoelectric element 2 at a part inside the support member 4 with the planar pressing face, the piezoelectric ceramic 2b was sufficiently deformed to have large strain, and the point where the strain value turns over was shifted toward the outer rim so that cancellation of the generated charge was reduced. Therefore, it was successful in obtaining the total electric energy 100 times as much as that of sample No. 1.

Sample No. 4 was the Example of the present invention, where the support member 4 supported the outer rim of the piezoelectric element 2, and the pressing member 3 had the ring pressing face which pressed the piezoelectric element 2 at a part inside the support member 4. Therefore, the piezoelectric ceramic 2b was sufficiently deformed to have large strain, and the point where the strain value turns over was shifted toward the outer rim so that cancellation of the generated charge was reduced. As a result, it was successful in obtaining the total electric energy 100 times as much as that of sample No. 1.

Example 2

First, piezoelectric elements 2 as shown in Figs. 1 to 4 were prepared in the same manner as in Example 1. Next, support members 4 to support an outer rim of the piezoelectric element 2 and pressing members 3 to press the piezoelectric element 2 at a part inside the support member 4 with a planar pressing face, which were as shown in Fig. 1, were prepared from materials having different hardnesses. Also, support members 4 to circularly support the outer rim of the piezoelectric element 2 and pressing members 3 to press the piezoelectric element 2 at a part inside the support member 4 with a ring pressing face were prepared from materials having different hardnesses. Next, the power generation members 1 having a combination as shown in Table 2 were prepared, where hardnesses of the support member 4 and pressing member 3 were referred to as Hs and Hp respectively. Thickness t from the electrode 2a to the electrode 2c as shown in Fig. 1 was measured with a dial gauge. Thereafter, each power generation member 1 was connected to a 1 MΩ resistance in parallel to form a circuit.

Each pressing member 3 was attached to a precision universal tester (AUTOGRAPH (registered trademark) AGS-J, Shimadzu Corp.). The piezoelectric element 2 was pressed at a rate of 200 mm/min so as to be subjected to a sharp load, and a load on the piezoelectric element 2 was measured every 0.05 sec with the precision universal tester. At the same time, voltage across the resistance and resistance value were detected every 0.05 sec with a digital electrometer (R8252, manufactured by Advantest Corp.). Then, electric energy at each time was calculated from the voltages and resistances detected in one cycle, which is defined as a period from the start of loading to 40 N, and the sum thereof was obtained as total electric energy $P_1$ The load was released after it reached 40 N, and then the load was applied again until it reached 40 N. This cycle was repeated for 50 times, and the electric energy at each time was calculated from the voltages and resistances detected in the 50th cycle. The sum thereof was obtained as total electric energy $P_{50}$. A decrease ratio $\Delta P$ of the total electric energy $P_{50}$ at the 50th cycle to the total electric energy $P_1$ at the first cycle (= $(P_1 - P_{50}) /P_1 \times 100$) (%) was calculated. The obtained values are shown in Table 2.

Regarding thickness t from the electrode 2a to electrode 2c measured with a dial gauge, one measured before applying a load was denoted as to, and one measured after 50 cycles was denoted as $t_{50}$. An increase ratio $\Delta t$ of the thickness t before applying a load to after 50 cycles (= $(t_{50} - t_0) /t_0 \times 100$) (%) was calculated. The obtained values are shown in Table 2. A large increase ratio $\Delta t$ means large plastic deformation of the piezoelectric element 2, and a small increase ratio $\Delta t$ means small plastic deformation of the piezoelectric element 2.

Table 2

| Sample No. | Corresponding figure of power generation member | Relation between Hs and Hp | Increase ratio of thickness $\Delta t$ (%) | Decrease ratio of total electric energy $\Delta P$ (%) |
|---|---|---|---|---|
| 5 | Fig. 1 | Hs = Hp | 8 | 80 |
| 6 | | Hs > Hip | 2 | 25 |
| 7 | | Hs < Hp | 6 | 65 |
| 8 | Fig. 4 | Hs = Hp | 7 | 75 |
| 9 | | Hs > Hp | 2 | 20 |
| 10 | | Hs < Hp | 6 | 60 |
| Hs: Hardness of support member 4<br>Hp: Hardness of pressing member 3<br><br>$\Delta t = (t_{50} - t_0)/t_0 \times 100$  $\Delta P = (P_1 - P_{50})/P_1 \times 100$ | | | | |

As apparent from the results shown in Table 2, the increase ratio $\Delta t$ of the thickness and the decrease ratio $\Delta P$ of the total electric energy were very low in samples No. 6 and 9, where the hardness Hp of the pressing member 3 is lower than the hardness Hs of the support member 4. Therefore, it was found that, when the hardness of the pressing member 3 is lower than that of the support member 4, the pressing member 3 absorbs and reduces an impact caused by a sharp load on the piezoelectric element 2, and the support member 4 prevents excess deformation.

Example 3

First, piezoelectric elements 2 as shown in Figs. 1 to 4 were prepared in the same manner as in Example 1. Next, pressing members 3 to press the piezoelectric element 2 at a part inside a support member 4 with a planar pressing face, pressing members 3 to press the piezoelectric element 2 at a part inside the support member 4 with a ring pressing face, first covering members 7 to hold the pressing member 3, and pressing members 3 integrally formed with the respective first covering members 7 were prepared. Also, support members 4 to support the outer rim of the piezoelectric element 2, second covering members 8 to hold the support member 4, and support members 4 integrally formed with the second covering member 8 were prepared. The power generation devices 6 having a combination shown in Table 3 were prepared from these members, and a 10 MΩ resistance was connected to each power generation member 1 to form a circuit.

In Table 3, "separated" denotes that the pressing member 3 or support member 4 is joined with the respective first or second covering members 7 and 8 by adhesion to hold them. Also in Table 3, "integral" denotes that the pressing member 3 or the pressing member 4 is integrally formed with the respective first covering member 7 or second covering member 8.

By use of a precision universal tester (AUTOGRAPH (registered trademark) AGS-J, Shimadzu Corp.), each piezoelectric element 2 was pressed with the first covering member 7 and pressing member 3 at a rate of 100 mm/min, and load applied on the piezoelectric element 2 was measured every 0.05 sec. At the same time, voltage across the resistance and resistance value were detected every 0.05 sec with a digital electrometer (R8252, manufactured by Advantest Corp.). Then, electric energy at each time was calculated from the voltages and resistances detected in one cycle, which was defined as a period from the start of loading to 80 N, and the sum thereof was obtained as total electric energy $P_1$. The load was released after it reached 80 N, and then the load was applied again until it reached 80 N. This cycle was repeated for 50 times, and the electric energy at each time was calculated from the voltages and resistances detected at the 50th cycle. The sum thereof was obtained as total electric energy $P_{50}$. A decrease ratio $\Delta P$ of the total electric energy $P_{50}$ at the 50th cycle to the total electric energy $P_1$ at the first cycle (= $(P_1 - P_{50})/P_1 \times 100$) (%) was calculated. The obtained values are shown in Table 3.

Table 3

| Sample No. | Shape of face of pressing first member | Formation pressing of pressing member and covering member | Formation of support member and second covering member | Decrease ratios of total electric energy ΔP (%) |
|---|---|---|---|---|
| 11 | Planar pressing face | Separate | Separate | 70 |
| 12 | | integral | Separate | 40 |
| 13 | | Separate | Integral | 60 |
| 14 | | Integral | Integral | 20 |
| 15 | Ring pressing integral face | Separate | Separate | 65 |
| 16 | | | Separate | 40 |
| 17 | | Separate | Integral | 60 |
| 18 | | Integral | Integral | 20 |

$$\Delta P = (P_1 - P_{50})/P_1 \times 100$$

As apparent from the results shown in Table 3, samples No. 12, 13, 16 and 17, in which any one of the pressing member 3 and support member 4 is integrally formed, showed low decrease ratios ΔP of the total electric energy, compared to samples No. 11 and 15, in which the pressing member 3 and support member 4 were joined with the respective first and second covering members 7 and 8 by adhesion to hold them. Comparing sample No. 12 with sample No. 13, sample No. 12 showed a lower decrease ratio ΔP of the total electric energy, since the pressing member 3 was integrally formed with the first covering member 7 and the piezoelectric element 2 was pressed without disalignment. Similarly, comparing sample No. 16 with sample No. 17, sample No. 16 showed a lower decrease ratio ΔP of the total electric energy, since the pressing member 3 was integrally formed with the first covering member 7 and the piezoelectric element 2 was pressed without disalignment.

Further, samples No. 14 and No. 18, where the pressing member 3 and support member 4 were integrally formed with the respective first and second covering members 7 and 8, showed very low decrease ratios ΔP of total electric energy. From these results, it has found that it is preferable to form the pressing member 3 and support member 4 integrally with the respective first and second covering members 7 and 8, in order that the pressing member 3 presses the piezoelectric element 2 and the support member 4 supports the piezoelectric element 2 without disalignment, to effectively generate electricity.

Example 4

First, a plurality of piezoelectric elements 2 having circular, triangular, rectangular, hexagonal and octagonal shapes in a plan view are prepared. Next, first covering members 7 which are integrally formed with respective pressing members 3 to press the piezoelectric element 2 at a part inside the support member 4 with a planar pressing face having the same shape with the electric element 2, and second covering members 8 which are integrally formed with the respective support members 4 to support an outer rim of the piezoelectric element 2. Then, power generation members 1 having circular, triangular, rectangular, hexagonal and octagonal shapes in a plan view were prepared from these members, and arrayed according to the alignments shown in Fig. 13 and Figs. 9(a) to 9(d), so that power generation devices were prepared. The power generation devices 6 had the same area. A 10 MΩ resistance was connected to each power generation device 6 to form a circuit.

Each power generation device 6 was stamped by one step of a 65 kg man walking at a speed of 112 steps/min, so that the piezoelectric element 2 was pressed via the first covering member 7 integrally formed with the pressing member 3. Voltage across the resistance and resistance value were detected every 0.05 sec with a digital electrometer (R8252, manufactured by Advantest Corp.). Then, electric energy at each time was calculated from the voltages and resistances detected during the one step, and the sum thereof was obtained as total electric energy. The total electric energy was shown as a relative value with respect to a total electric energy of sample No. 19 as 1, where the power generation members 6 had the piezoelectric elements 2 and pressing members 3 of a circular shape in a plan view as show in Fig. 13. The results are shown in Table 4.

Table 4

| Sample No. | Shape of power generation member 1 plan view | Corresponding figure of power in a generation device | Relative value with respect to total respect to total electric energy of sample No. 19 |
|---|---|---|---|
| 19 | Circular | Fig. 13 | 1 |
| 20 | Triangular | Fig. 9(a) | 1.3 |
| 21 | Rectangular | Fig. 9(b ) | 1.5 |
| 22 | Hexagonal and triangular | Fig. 9(c) | 1.8 |
| 23 | Octagonal and rectangular | Fig. 9 (d) | 2.0 |

As apparent from the results shown in Table 4, compared to sample No. 19 in which the power generation members 1 had a circular shape in a plan view, the total electric energies was larger in all of sample No. 20 in which the power generation members 1 had a triangular shape in a plan view and were arrayed as shown in Fig. 9(a), sample No. 21 in which the power generation members 1 had a rectangular shape in a plan view and were arrayed as shown in Fig. 9(b), sample No. 22 in which the power generation members 1 had hexagonal and rectangular shapes in a plan view and were arrayed as shown in Fig. 9(c), and sample No. 23 in which the power generation members 1 had octagonal and rectangular shapes in a plan view and were arrayed as shown in Fig. 9(d). In view of these results, it has found that the power generation members 1 having triangular, rectangular, hexagonal and octagonal shapes in a plan view are preferable since a plurality of such power generation members 1 can be arrayed closely in a plane with little space between them, so as to achieve large power generation capacity.

**Claims**

1. A power generation member comprising:

    a piezoelectric element composed of a plate-shaped piezoelectric ceramic and electrodes formed on both main faces of the plate-shaped piezoelectric ceramic;
    a pressing member to press one main face of the piezoelectric element; and
    a support member to support the other main face of the piezoelectric element,
    wherein the support member supports an outer rim of the piezoelectric element, and the pressing member presses the piezoelectric element with a planar pressing face at a part inside the support member.

2. A power generation member comprising:

    a piezoelectric element composed of a plate-shaped piezoelectric ceramic and electrodes formed on both main faces of the plate-shaped piezoelectric ceramic;
    a pressing member to press one main face of the piezoelectric element; and
    a support member to support the other main face of the piezoelectric element,
    wherein the support member supports an outer rim of the piezoelectric element, and the pressing member presses the piezoelectric element with a ring pressing face at a part inside the support member.

3. A power generation member comprising:

    a piezoelectric element composed of a plate-shaped piezoelectric ceramic and electrodes formed on both main faces of the plate-shaped piezoelectric ceramic;
    a pressing member to press one main face of the piezoelectric element; and
    a support member to support the other main face of the piezoelectric element,
    wherein the power generation member has a triangular, rectangular, hexagonal or octagonal shape in a plan view.

4. The power generation member according to any one of claims 1 to 3, wherein the pressing member is composed of a material having a lower hardness than that of the support member.

5. The power generation member according to any one of claims 1 to 4, wherein the piezoelectric ceramic is composed of lead zirconate titanate.

6. The power generation member according to any one of claims 1 to 4, wherein the piezoelectric ceramic comprises potassium-sodium-lithium niobate as a main component, and further comprises calcium titanate and bismuth ferrite.

7. A power generation device comprising:

    a plurality of the power generation members according to any one of claims 1 to 6 arrayed in a plane,
    wherein the pressing members are held by respective plate-shaped first covering members, and the support members are held by respective plate-shaped second covering members.

8. The power generation device according to claim 7, wherein the pressing members are integrally formed with the respective first covering members.

9. The power generation device according to claim 7, wherein the support members are integrally formed with the respective second covering members.

10. A power generation system comprising:

    a power generation device according to any one of claims 7 to 9; and
    a DC-AC converter connected via a circuit comprising a diode and a capacitor.

11. A power generation system comprising:

    the power generation device according to any one of claims 7 to 9 placed on a floor, stairs, road, bridge or parking lot, or under a railway track.

Fig.1

(a)

(b)

(c)

Fig.2

(a)

(b)

(c)

Fig.3

(a)

(b)

(c)

Fig.4

( a )

( b )

( c )

Fig.5

(a)

(b)

(c)

Fig.6

(a)

(b)

(c)

Fig.7

(a)

(b)

(c)

Fig.8

(a)

2 a
2 b    2
2 c
5
4

1
3
H
H'

(b)

3
1
2 a
2 b    2
2 c
5
4

(c)

1
3
2 a
2 b    2
2 c
5
4

Fig.9

(a)

(b)

(c)

(d)

Fig.10

(a)

6

V

(b)

6

7

J

J'

2 {
2 a
2 b
2 c
}

3
2
4
8

} 1

(c)

6

7

2 {
2 a
2 b
2 c
}

3
2
4
8

} 1

Fig.11

(a)

(b)

(c)

Fig.12

(a)

(b)

(c)

Fig.13

(a)

(b)

(c)

Fig.14

Fig.15

Fig.16

Fig.17

(a)

26

25

23

24

25

26

(b)

20

26

25

23

24

25

26

## INTERNATIONAL SEARCH REPORT

International application No.

PCT/JP2009/070036

A. CLASSIFICATION OF SUBJECT MATTER
*F03G7/08*(2006.01)i, *H01L41/113*(2006.01)i, *H01L41/187*(2006.01)i, *H01L41/22*
(2006.01)i, *H01L41/24*(2006.01)i, *H02N2/00*(2006.01)i

According to International Patent Classification (IPC) or to both national classification and IPC

B. FIELDS SEARCHED

Minimum documentation searched (classification system followed by classification symbols)
F03G7/08, H01L41/113, H01L41/187, H01L41/22, H01L41/24, H02N2/00

Documentation searched other than minimum documentation to the extent that such documents are included in the fields searched
Jitsuyo Shinan Koho        1922-1996    Jitsuyo Shinan Toroku Koho    1996-2010
Kokai Jitsuyo Shinan Koho  1971-2010    Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2008-211095 A  (National Institute of Advanced Industrial Science and Technology), 11 September 2008 (11.09.2008), paragraphs [0092] to [0095]; fig. 3 (Family: none) | 1-4,7-11<br>5,6 |
| Y | JP 2008-054450 A  (Murata Mfg. Co., Ltd.), 06 March 2008 (06.03.2008), paragraph [0030] (Family: none) | 5 |
| Y | JP 2007-294593 A  (Hitachi Cable, Ltd.), 08 November 2007 (08.11.2007), paragraph [0003] (Family: none) | 6 |

☒ Further documents are listed in the continuation of Box C.     ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
19 February, 2010 (19.02.10)

Date of mailing of the international search report
09 March, 2010 (09.03.10)

Name and mailing address of the ISA/
Japanese Patent Office

Authorized officer

Facsimile No.

Telephone No.

Form PCT/ISA/210 (second sheet) (April 2007)

**EP 2 362 096 A1**

**INTERNATIONAL SEARCH REPORT**

International application No.

PCT/JP2009/070036

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-166881 A (Taiheiyo Cement Corp.), 28 June 2007 (28.06.2007), entire text; all drawings (Family: none) | 1 |
| A | JP 2006-158111 A (Matsushita Electric Works, Ltd.), 15 June 2006 (15.06.2006), fig. 1 (Family: none) | 1 |

Form PCT/ISA/210 (continuation of second sheet) (April 2007)

36

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006197704 A
- JP H11353913 A
- JP H0539661 A
- JP 5039661 A